# EUROPEAN PATENT SPECIFICATION

(11) **EP 2 033 207 B1**
(45) Date of publication and mention of the grant of the patent: **01.11.2017**
(21) Application number: 07748765.0
(22) Date of filing: 07.06.2007
(51) Int. Cl.: H01J 37/32, H01L 21/67

(54) **METHOD FOR CLEANING, ETCHING, ACTIVATION AND SUBSEQUENT TREATMENT OF GLASS SURFACES, GLASS SURFACES COATED BY METAL OXIDES, AND SURFACES OF OTHER SIO2-COATED MATERIALS**
VERFAHREN ZUM REINIGEN, ÄTZEN, AKTIVIEREN UND NACHFOLGENDEN BEHANDELN VON GLASOBERFLÄCHEN, DURCH METALLOXIDE BESCHICHTETEN GLASOBERFLÄCHEN UND OBERFLÄCHEN ANDERER SIO2-BESCHICHTETER MATERIALIEN
PROCEDE POUR LE NETTOYAGE, L'ATTAQUE CHIMIQUE, L'ACTIVATION ET TRAITEMENT SUBSEQUENT DE SURFACES DE VERRE, SURFACES DE VERRE REVETUES D'OXYDES METALLIQUES, ET SURFACES D'AUTRES MATERIAUX REVETUS DE SIO2

(30) Priority: 08.06.2006 SK 50522006
(43) Date of publication of application: 11.03.2009
(73) Proprietor: Masarykova Univerzita, 602 00 BRNO 2 (CZ)
(72) Inventor: CERNAK, Mirko, 842 07 Bratislava (SK)
(74) Representative: Danek, Vilém
(86) International application number: PCT/SK2007/050013
(87) International publication number: WO 2007/142612

(56) References cited:
- EP-A- 1 073 091
- EP-A- 1 548 795
- EP-A1- 0 803 342
- EP-A1- 1 387 901
- WO-A-02/23960
- WO-A-2005/062338
- US-A1- 2005 145 174
- US-A1- 2005 161 433
- BLETZINGER P ET AL: "The effect of displacement current on fast-pulsed dielectric barrier discharges" JOURNAL OF PHYSICS D. APPLIED PHYSICS, IOP PUBLISHING, BRISTOL, GB, vol. 36, no. 13, 18 June 2003 (2003-06-18), pages 1550-1552, XP002310826 ISSN: 0022-3727

## Description

### Technical Field

The invention relates to a method for fast and safe cleaning, etching and activation of glass surfaces, glass surfaces coated with metal oxides, and surfaces of other SiO₂-coated materials by effects of diffuse electrical plasmas generated at near-atmospheric gas pressures using coplanar surface barrier discharges. The invention relates also to the subsequent surface treatments of such plasma-treated surfaces.

### Background Art

Glass surfaces and surfaces of other SiO₂ -coated materials as, for example, Si wafers coated with native or artificial layers of SiO₂, polymer foils coated with SiO₂-containing barrier layers, surfaces of metallic foils and other metallic materials coated with SiO₂-based protective layers, ceramic surfaces coated with a SiO₂-containing glaze often do not posses the needed properties to allow for their applications, or for their subsequent surface treatments. The surfaces can be, for example, contaminated by organic contaminants as oils and organic molecules adsorbed from the air, and contaminated by biological materials such as bacteria and viruses. The surfaces, for example, in flat panel display manufacturing, can be coated with photoresist and polymer layers. Often it is necessary to remove such a surface contamination or coating to allow for the material applications or for its subsequent treatments and surface modifications such as in bonding, dyeing, metal plating, lamination, etc.

As described in, for example, W.R. Birch: "Coatings: An introduction to the cleaning procedures" The Sol-Gel Gateway, June 2000, www.solgel.com and U.S. patent application 20010008229, wet cleaning methods using organic solvents such as isopropyl alcohol, aggressive aqueous acid and alkaline solutions, hot water, and ultrasound cleaning in a water bath are widely used to clean the surfaces of glass and other SiO₂-coated materials.

Because of environmental and technical reasons it is advantageous to clean glass surfaces and surface of SiO₂ -coated materials using the dry cleaning methods such as by heating, usually for more than 30 minutes, at temperatures above 300°C, by exposure to ozone advantageously in combination with an UV light irradiation as described in, for example, U.S. patent application 20050076934, by laser irradiation as described in D. R. Halfpenny et al.: Applied Physics A: Materials Science & Processing 71 (2000) 147 - 151, and by exposure to electrical plasmas as described in, for example, U.S. Pat. No. 5,028,453, S. Tada et al.: Jpn. J. Appl. Phys. 41 (2002) 6553-6556, A. Nakahira et al.: Science and Engineering of Composite Materials 8 (1999) 129-136, E. Kondoh et al.: Journal of Vacuum Science & Technology B: Microelectronics and Nanometer Structures 18 (2000) 1276-1280, M. Syed et al.: Jpn. J. Appl. Phys., Part 1, 41 (2002) 263-269., K-B Lim a D-Ch. Lee: Surface and Interface Analysis 36 (2004) 254-258, O. Sneh et al.: J. Phys. Chem. 99 (1995) 4639-4647, B. J. Larson et al.: Biosensors and Bioelectronics 21 (2005) 796-801, R. Winter et al.: Surface and Coatings Technology 93 (1997), 134-141 (8), and in U.S. Pat. Appl. No. 20040265505.

As stated in Cleaning and Degreasing Process Changes, United States Environmental Protection Agency, EPA1625/R-93/017, February 1994, the principle of plasma cleaning is identical to the principle of plasma etching. Consequently, in agreement with, for example, C. H. Yi, Y. H. Lee, G. Y. Yeom: "The study of atmospheric pressure plasma for surface cleaning", Surface and Coatings Technology 171 (2003) 237-240, the plasma cleaning as used herein refers to the removal of organic surface contaminants and layers including photoresist films.

In many applications, preferably in bonding of other molecules to glass surfaces and SiO₂-coated surfaces, besides the surface cleaning and etching, it is required to activate the surface. That means, as described in U.S. Pat. Appl. No. 20050000248, to change the relatively inert siloxane surface groups into reactive hydrated silanol SiOH surface groups, which results also in a significant surface energy increase. As referred in A. V. Gorokhovsky et al.: Journal of Adhesion Sci. and Technol. 14 (2000) 1657-1664, a similar activation resulting in an increase in surface polar groups density and in an enhancement of the surface energy is advantageous also for metal-oxide-coated strengthened float glass. As described in Chung-Kyung Jung et al.: Surface & Coating Technology 200 (2005) 1320, the plasma treatment is advantageous also for surface cleaning and activation of TiO₂-coated glass surfaces.

From this aspect, as opposed to, for instance, glass cleaning using heat or laser, the application of plasma is very advantageous, as at adequately chosen conditions, the surface can be cleaned and activated at the same time. In accordance with the definition in H. Hermann: "Atmospheric Pressure Plasma Jet for Glass Processing", GLASS PROCESSING DAYS 2005 - www.gpd.fi, pp. 1-3, we will refer to all the above described effects of plasma as to plasma treatment.

A disadvantage of the majority of known devices for the plasma surface treatment of glass and other SiO₂-coated materials is that the plasma is generated at gas pressures below 1 kPa, which results in increased cost and in the requirement for skilled personnel, the impossibility of treating materials in a continuous mode, and high cost of treating workpieces with large dimensions. In addition, low-pressure plasma cleaning, plasma etching, and plasma activation require a long plasma exposure time of the order of minutes.

As a solution to this problem the atmospheric pressure plasma devices have already been designed and developed, the majority of them being based on the use of volume dielectric barrier discharges, as described in T. Yamamoto et al.: Plasma Chemistry and Plasma Processing 24(2004)1-12 and Ch. Wang and X. He: "Preparation of hydrophobic coating on glass surface by dielectric barrier discharge using a 16 kHz power supply", Applied Surface Science (2006), as well as used in the devices SPOX-C made by OTB Oberflaechentechnik, Germany, and AT 2000 by ITM Inc., South Korea. When such volume barrier discharges, termed also the industrial corona discharges, are used for an in-situ plasma treatment, the treated material is situated between two electrodes applied to a high-frequency high-voltage signal, where the displacement electric current lines emanating from the electrodes are crossing the treated material and the discharge plasma volume. The volume barrier discharges can be generated in any working gas, including air and oxygen. A disadvantage of this solution consists in that the discharge plasma characteristics depend on the treated material thickness and, consequently, is not possible to treat thick materials. A further disadvantage of this solution consists in that the volume plasma power density is relatively low and, consequently, the required plasma exposure time is of the order of 10 to 100 seconds. Another disadvantage of such a solution is that an increase in the plasma power density leads to an undesirable plasma filamentation and dramatic increase in the plasma gas temperature, resulting in nonuniform treatment and in roughening of the glass, strengthened float glass, and SiO₂ -coated surfaces.

To increase the plasma power density and, consequently, to reduce the plasma exposure times without the mentioned nonuniform treatment and damages to the treated material surface, the plasma devices generating diffuse atmospheric-pressure plasmas without filamentation and sparking were designed. The devices are based on the use of the so-called atmospheric pressure glow discharges, and their use for the glass surface cleaning and activation is described in, for example, C. H. Yi et al.: Surface and Coatings Technology 171 (2003) 237-240, in B. Das: J. Adhes. Sci. Technol. 10 (1996) 1371-1382 and in U.S. Pat. Appl. No. 20050045103. This principle is used also in the devices Atomflo™ manufactured by Surfx Technologies, and APIS-F™ by Radiiontech. Similar principle termed plasma-jet and its use for the glass surface treatment is described in H. Hermann: "Atmospheric Pressure Plasma Jet for Glass Processing":GLASS PROCESSING DAYS 2005 - www.gpd.fi, pp.1-3.

As discussed in the last mentioned publication, the common disadvantage of such devices is that the helium-containing working gas is to be used for preventing the plasma filamentation and gas heating, i.e., to generate diffuse cold plasma. Helium has a stabilising effect making it possible to generate diffuse cold plasma, but besides the costs associated with using large amounts of helium, it also presents an unfortunate restriction of the working range. A further disadvantage is that to prevent the sparking and working gas heating, it is necessary to generate the plasma in a large volume of flowing working gas, which increases significantly the energy and working gas consumption. An additional disadvantage of the plasma jet devices is that the plasma is generated in a distance from the treated glass surface greater than 1 mm. This, together with the flowing working gas, result in recombination and decay of a significant portion of the plasma active species without their contact with the treated surface, resulting in a low energy efficiency of such devices. A further disadvantage of some of such devices, as that described in U.S. Pat. Appl. No. 20050045103, is a direct contact of the discharge plasma with metallic electrode surface and resulting electrode surface erosion with a consequence of a limited life cycle of the device. Yet another disadvantage of such devices, except for that described in H. Hermann: "Atmospheric Pressure Plasma Jet for Glass Processing", GLASS PROCESSING DAYS 2005 - www.gpd.fi, pp. 1-3 and as discussed, for example, in A. P. Napartovich: Plasmas and Polymer 6 (2001) 1-14, is that the plasma power density is only of the order of 1 to 10 W/cm³, resulting in too long plasma exposure times of the order of 10 seconds for glass surface cleaning and activation. A further disadvantage of such devices is that that the plasma is usually not safe in an unintended contact with the human body.

Document WO 02/23960 discloses an electrode assembly for producing a glow-discharge plasma at substantially atmospheric pressure using porous electrodes.

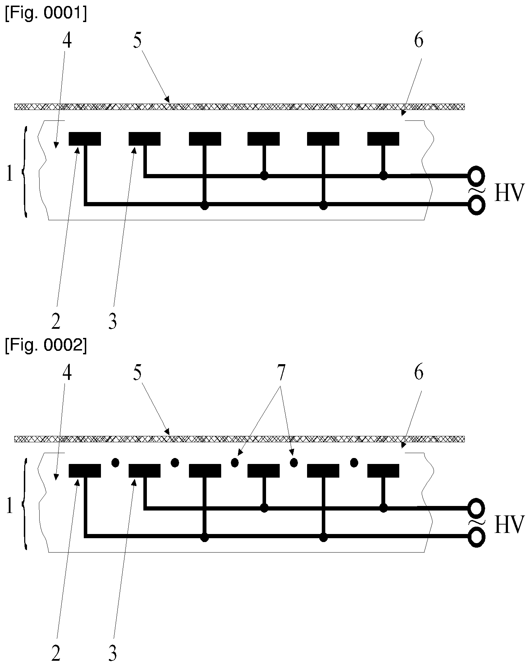

Document EP1387901 discloses electrode systems according to figures 1 and 2, and a method according to the preamble of claim 1.

### Disclosure of Invention

The method according to the present invention is defined in claim 1.

The above discussed disadvantages are solved by the present invention, where the glass surfaces, glass surfaces coated with metal oxides or with polymer materials, and surfaces of other SiO₂-coated materials are exposed to a thin layer non-equilibrium plasma, preferably with a thickness ranging from 0.05 mm to 1 mm. The plasma layer is generated on a portion of a dielectric body surface, advantageously the body made from a ceramics or glass, preferably on the dielectric body surface above the surfaces of conductive electrodes situated inside of the dielectric body. The plasma exposed glass surfaces, glass surfaces coated with a metal oxide or with a polymer material, and surfaces of other SiO₂-coated materials are situated in a vicinity of the dielectric body surface on which the plasma layer is generated, closer than 1 mm and farther than 0.05 mm, from the dielectric body surface on which the plasma layer is generated.

The plasma is generated in any working gas, preferably in the working gas not containing He and containing molecules of N₂, O₂, H₂O, CO₂, and halohydrocarbon molecules. The plasma is generated at gas pressures ranging from 1 kPa to 1000 kPa, preferably at atmospheric pressure and, preferably, using working gas flow velocity less than 10 m/s.

The plasma layer is generated on the surface of a dielectric body, which is separating conductive electrodes situated inside of the dielectric body, in such a way that the electrodes surfaces are not in contact with the plasma. The electrodes are energized by an alternating or pulsed electrical voltage with a frequency ranging from 50 Hz to 1 GHz and a magnitude from 100 V to 100 kV. The minimum interelectrode distance is less than 2 mm and more than 0.05 mm.

The electrodes are situated in such a way that a significant portion of the Maxwell's displacement current, which is larger than 25% of the total Maxwell's displacement current flowing between the electrodes separated by a layer of the dielectric material and supplied with alternating electric voltage, is not intersecting plasma or the treated material surface.

It was found surprisingly that using the method in accordance with the invention, it is possible to generate, above the surface of conductive electrodes positioned in a dielectric material in the above-described manner, visually diffuse strongly nonequilibrium plasmas with high power densities reaching the order of 100 W/cm³ suitable for fast cleaning and activating of glass, metal-oxide coated glass or SiO₂-coated glass at exposure times of the order of 0.1 to 1 s. An advantage of the solution in accordance with the invention is that such diffuse plasma can be generated even without a high working gas flow and without using a helium-containing working gas. It was found surprisingly that the homogeneity of plasma so generated, as opposed to all known plasma devices tested previously for the above-mentioned purpose, increases with growing plasma power density.

Another surprising finding is that the plasma uniformity, diffusivity and power density is increased by situating the treated glass, metal-oxide coated glass, or SiO₂-coated material surface in a distance from 0.05 to 1 mm, preferably from 0.2 to 0.3 mm, from the dielectric body surface on which the plasma layer is generated. Another surprising finding is that plasma so generated is safe in contact with the surface of human body. Yet another surprising finding is that the exposure to the plasmas so generated at exposure times shorter than 10 seconds does not result in any roughening greater than 10 nm.

### Brief Description of Drawings

Examples of the electrode systems used in the method according to the invention are described schematically in the attached figures. The illustrations in the figures are confined to the planar electrode systems.
Figure 1 is a schematic cross-sectional view illustrating a part of the planar electrode system that can be an essential part of the apparatus for the plasma treatment of glass surfaces, glass surfaces coated with a metal oxide or with a polymer material, and surfaces of other SiO₂ -coated materials. The treated substrate surface is situated at a distance of not more than 1 mm from the electrode system.
Figure 2 illustrates a part of the apparatus for the plasma treatment of glass surfaces, glass surfaces coated with metal oxides and surfaces of other SiO₂ -coated materials, equipped with an auxiliary electrode.

### Mode(s) for Carrying Out the Invention

### Example 1

The method according to the present invention was used to activate a glass surface with the aim to increase the adhesive strength of a polymer layer extruded onto the glass surface. The surface of 10-mm-thick float glass plate was activated by 0.5 s exposure to ambient air plasma generated using the device according to the present invention at a power density of 10 W/cm². Several seconds after the activation a 2 mm thick polymer layer of Dow Corning® Instant Glaze was extruded onto the glass surface at 120°C. The dynamic peel strength value measured according to ASTM C-794 was 16 kN/m. For comparison, an identical layer of Dow Corning® Instant Glaze was coated onto the surface of glass cleaned in the standard manner using isopropyl alcohol. In this case, the dynamic peel strength value measured was 8.5 kN/ m.

### Example 2

The method and device according to the present invention were used to activate edges of a float glass plate before the strengthening of the glass plate by an epoxy coating of the glass edges.

Glass strips of size 400 mm long and 40 mm wide were cut from glass plates with thickness of 10 mm using a rotary diamond wheel cutter of 175 mm in diameter, 70 microns grain, at a rotation speed of 3000 rev/min., ground and polished in the direction perpendicular to the glass surface. The glass edges were cleaned with isopropanol.

The strength of the strips was tested using a 3 point bending method as described in details in F. A. Veer and J. Zuidema: "The Strength of Glass, Effect of Edge Quality", Glass Processing Days 2003, 106-109. The average failure strength of the ground-edge strips was 54 MPa. When the strip edges were coated with a 0.25 mm thick epoxy film, the average failure strength was increased to 98 MPa. When the edges were plasma activated by a 2 s ambient-air plasma exposure at each of the three edge surfaces, the subsequent epoxy edge coating increased the failure strength to 132 MPa.

### Example 3

A monocrystalline silicone wafer with a native SiO₂ layer was cleaned with isopropanol. Subsequently, a 3% phosphoric acid solution in distilled water was sprayed on the cleaned wafer surface. Because of a low surface energy of the wafer, the surface was not coated with the sprayed phosphoric acid solution homogeneously, but the sprayed droplets tend to coalesce into bigger droplets. In the next experiment, the wafer surface was treated in the same manner with a 3% H PO solution in distilled 3 4 water with an addition of a surfactant, which resulted in a nonuniform coating taking the form of a flat film with a significant part of its area opened with holes. When the wafer surface was treated using the method according to the present invention for 3 seconds in the atmospheric-pressure oxygen plasma at a power of 5 W/cm² without isopropyl alcohol rinsing, the sprayed solution of 3% H₃PO₄ solution in distilled water formed a uniform film on the surface without the use of surfactant.

### Example 4

Using a planar DC magnetron sputtering system, glass surface was coated with a 150 nm thick indium tin oxide (ITO) film. The ITO-coated glass substrate was cleaned with detergent/deionised water followed by rinsing in acetone. The cleaned ITO-coated glass surface was treated using the method according to the present invention for 3 seconds in an atmospheric-pressure CO₂ plasma at a power density of 5 W/cm². Such a plasma-treated TIO-coated glass substrate was advantageously used to prepare organic light emitting devices according to the procedure described in C. C. Wu et al.: Appl. Phys. Lett. 69 (1996) 3117.

### Example 5

A 3.10⁻⁶ m thick SiO₂ layer was prepared on Si(100) surface by combining a thermal oxidation and CVD deposition from a SiH₄ and O₂ gas mixture. Such a porous low-quality SiO₂ layer was subsequently cleaned using the method and device according to the present invention for 30 seconds in a H₂O vapour-saturated atmospheric-pressure O ₂ plasma at a power density of 5 W/cm². Subsequently, the cleaned sample was baked in an oven at 900°C for 1 h to prepare a pure high-quality glassy SiO₂ layer on the Si substrate.

### Example 6

A 4-inch diameter silicone wafer coated with a 0.6-nm-thick native SiO₂ layer with a surface energy of 52 mN/m as determined by a water contact angle measurement was treated using the method according to the present invention. The aim was to increase the surface energy, i.e. to make the surface more hydrophilic, to activate the wafer surface, i.e., to increase surface OH groups density, and in this way to improve the adhesive properties in direct wafer bonding.

The wafers were situated 0.4 mm from the electrode system surface and exposed for 3 seconds to the plasma generated in atmospheric-pressure oxygen. After the treatment, the surface energy was increased to 61 mN/m. Exposing the wafer to the standard wet RCA-1 treatment resulted in an increase of the surface energy to only 55 mN/m. Subsequently, two wafers were contacted by the treated surfaces and bonded directly, i.e., without the use of an adhesive, in a clean room ambient at a temperature of 220°C, using a force of 50 N for 3 hours. The bonding energy value measured by the standard crack opening method, as described in W.P. Maszara et al.: J. Appl. Phys. 64 (1988) 4943, was of 1.4 J/m² for O₂ the plasma treated wafers, and 0.65 J/m² for the RCA-1 wet method activated wafers.

### Example 7

Two Si wafers coated with a 0.6-nm-thick native SiO₂ were a) etched for 10 minutes in a 10% solution of HF in deionised water, or b) treated using the method according to the present invention for 10 s in atmospheric pressure H₂ plasma. Following both types of treatment, the wafers were rinsed with deionised water for 20 minutes and subsequently dried using a nitrogen stream. The wafers treated using both methods had SiO₂ free surfaces with the wafer surface becoming hydrophobic having a contact angle with water of approximately 70°. Wafers treated as described were brought into mechanical contact immediately following the treatment and thus bonded. The surface energy measured by the crack opening method for the wafers treated using the method b) was about a factor two higher than for those treated by the method a).

### Example 8

With the objective of coating the glass with a continuous hydrophilic layer of TiO₂ thicker than 100 nm, a mixture of ethanol and acetic acid was prepared with an addition of titanium tetraisopropoxide and the solution was left to stand for 3 hours. The glass surface was cleaned and activated using the device and method according to the invention by a 0.5 second atmospheric-pressure oxygen plasma exposure at a power density of 10 W/cm². The above-described solution without surfactant addition was sprayed on the plasma-treated surface. Subsequently, the glass substrate was baked in an oven at 400°C for 1 h. However, the 50 nm thick TiO₂ layer thus prepared lacked the required properties and was not wettable by the above-mentioned solution due to residual alkoxy groups. To improve the properties of the TiO₂-coated glass, the TiO₂-coated glass was cleaned and activated using a 3 seconds atmospheric-pressure oxygen plasma exposure at a power density of 10 W/cm² generated by the device and method according to the invention. The glass surface so plasma-treated could be coated, by repeating the above-described procedure, with further TiO₂ layers having good mechanical properties with no cracks.

### Example 9

A 300-nm thick TiO₂-coating was prepared on a glass substrate by magnetron sputtering method. When the sample was aged in laboratory air, an equilibrium water contact angle of 66° was measured. The method and device according to the present invention was used to activate the aged TiO₂-coated glass substrate by a 2 seconds atmospheric-pressure oxygen plasma exposure at a power density of 10 W/cm². The activation resulted in a low water contact angle of 10° and in significant improvement in hydrophilicity and photo-catalytic properties of the sample.

### Example 10

A 4-inch-diameter Si wafer with a native 0.6-nm thick SiO₂ layer was coated with a AZ1512 photoresist film using spin coating at 4000/min for 30 seconds. Subsequently, the layer thus prepared was baked at 120°C for 30 min. The photoresist film was exposed to the atmospheric-pressure oxygen plasma at a power of 20 W/cm² and 0.5-mm distance between the substrate and the electrode system using the device and method according to the invention. In these conditions the measured etching rate was 220 nm/min.

### List of the reference symbols used

- **1**: electrode system
- **2**: system of electrically conductive electrodes
- **3**: system of electrically conductive electrodes
- **4**: dielectric body
- **5**: glass, metal oxide coated glass, SiO2-coated article, or SiO2-coated article with a layer of organic material
- **6**: electrical plasma layer
- **7**: auxiliary electrode structure

## Claims

1. *A method for cleaning, etching, activation of glass surfaces, glass surfaces coated with metal oxides or with organic material layers, SiO₂-layer coated materials, and SiO₂*-*layer coated materials with an organic material surface* coating (5), *the glass surface, glass surface coated with metal oxide or with organic material layer, SiO₂-layer coated material, or SiO₂-layer coated material with an organic material surface coating being affected by electrical plasma* (6) *generated using an electrode system* (1) *comprising at least two electrically conductive electrodes* (2, 3) *situated inside of a dielectric body* (4) *on the same side of the glass, metal oxide coated glass or SiO₂-coated materials treated, the electric plasma layer being generated on the part of this dielectric body's surface without contact with the electrically conductive electrodes, **characterised in that***
*a significant portion of the Maxwell's displacement current, which is larger than 25* % *of the total Maxwell's displacement current flowing between the electrodes, is not intersecting the plasma or the plasma treated material and where the minimum distance between the portion of the dielectric body* (4) *surface coated with the plasma layer* (6) *and the glass, metal oxide coated glass, or SiO₂-coated material surface* (5) *is less than 1* mm and more than 0.05 *mm, wherein the surface treated can further be subject to:*
- *deposition of a water containing solution, water containing suspension, or water containing emulsion in the form of an aerosol, electrically charged aerosol, foam, printing or painting,* or
- *exposition to a gaseous atmosphere containing a monomer vapour,* or
- *coating with a layer of a polymer material using extrusion, lamination, printing, painting, spraying, or electrostatically using a powder,* or
- *bringing the surface in contact with another surface treated according to the above method,* or *with another solid material.*

## Patentansprüche

1. *Die Art für die Reinigung, das Ätzen und die Aktivierung der Oberfläche des Glases, des Glases, das mit einer Schicht aus Metalloxiden oder mit einer Schicht aus organischen Materialien bedeckt ist, Materialien, die mit einer Schicht SiO₂ bedeckt sind, und Materialien die mit einer Schicht SiO₂ bedeckt sind, auf der sich Schichten (5) eines organischen Materials befinden, wo auf der Oberfläche des Glases, des Glases, das mit einer Schicht aus Metalloxid oder mit einer Schicht aus organischem Material bedeckt ist, aus Material, das mit einer Schicht SiO₂ bedeckt ist, auf dem sich eine Schicht eines organischen Materials befindet, die durch ein elektrisches Plasma (6) bewirkt wird, die mit Hilfe eines Systems (1) von elektrisch leitenden Elektroden generiert wird, das wenigstens zwei elektrisch leitende Elektroden (2, 3) einschließt, die im Inneren des Körpers (4) angebracht sind, aus dielektrischem Material auf der gleichen Seite des Glases, des Glases, das mit einer Schicht aus Metalloxiden bedeckt ist oder von Materialien, die mit einer Schicht SiO₂ bedeckt sind, wobei die Schicht des elektrischen Plasmas auf Teile dieser Oberfläche des Körpers aus dielektrischem Material ohne Kontakt mit den elektrisch leitenden Elektroden generiert wird, **zeichnet sich dadurch aus, dass***
*ein bedeutender Teil des Maxwellschen Verschiebungsstroms, der größer als 25 % vom gesamten Maxwellschen Verschiebungsstrom ist, der zwischen den Elektroden strömt, nicht durch das Plasma oder durch das Material, das mit Plasma bearbeitet ist, durchgeht, und wo die minimale Entfernung zwischen dem Teil der Oberfläche des Körpers (4) aus dielektrischem Material, das mit einer Schicht (6) Plasma bedeckt ist und der Oberfläche aus Glas, des Glases, das mit einer Schicht Metalloxid bedeckt ist oder mit einer Schicht (5) eines Materials, das mit SiO₂ bedeckt ist, kleiner als 1 mm und größer als 0,05 mm ist, wobei die bearbeitete Oberfläche weiterhin ausgesetzt werden kann:*
- *der Einlegung in eine Lösung, die Wasser enthält, eine Suspension, die Wasser oder eine Emulsion in der Form eines Aerosols, eines elektrisch geladenen Aerosols, Schaums, Aufdrucks oder Anstrichs enthält, oder*
- *einer Exposition eines gasförmigen Milieus, das Dämpfe eines Monomers enthält, oder*
- *einer Auftragung einer Schicht eines polymeren Materials mit Hilfe von Extrusion, Laminierung, Aufdruck, Anstrich, Aufsprühung oder elektrostatisch unter Anwendung von Pulver, oder*
- *der Bringung der Oberfläche in Kontakt mit einer weiteren Oberfläche, die gemäß der oben aufgeführten Art hergerichtet ist, oder mit einem anderen festen Material.*

## Revendications

1. *Procédé de nettoyage, de gravure et d'activation de la surface du verre, du verre recouvert d'une couche d'oxydes de métaux ou d'une couche de matériaux organiques, de matériaux recouverts d'une couche de SiO₂ et de matériaux recouverts d'une couche de SiO₂ sur laquelle se trouve une couche (5) de matériaux organiques, lors duquel la surface du verre, du verre recouvert d'un oxyde de métal ou d'une couche de matériau organique, de matériau recouvert d'une couche de SiO₂ ou de matériau recouvert d'une couche de SiO₂ sur laquelle se trouve une couche de matériau organique, est exposée à un plasma électrique (6) généré par un système (1) d'électrodes conductrices d'électricité comprenant au moins deux électrodes conductrices (2, 3) placées à l'intérieur d'un corps (4) en matériau diélectrique, du même côté du verre, du verre recouvert d'une couche d'oxydes de métaux ou de matériaux recouverts d'une couche de SiO₂, en sachant que la couche de plasma électrique est générée sur la partie de la surface du corps en matériau diélectrique sans contact avec les électrodes conductrices d'électricité, **caractérisé en ce que***
*une partie significative du courant de déplacement de Maxwell, supérieure à 25 % de l'intégralité du courant de déplacement de Maxwell qui passe entre les électrodes, ne traverse pas le plasma ou le matériau traité au plasma et où la distance minimale entre la partie de la surface du corps (4) en matériau diélectrique qui est recouverte d'une couche (6) de plasma et la surface du verre, du verre recouvert d'un oxyde de métal ou d'une couche (5) de matériau recouvert d'une couche de SiO₂ est inférieure à 1 mm et supérieure à 0,05 mm, en sachant que la surface traitée peut ensuite être exposée à :*
- *un dépôt dans une solution contenant de l'eau, dans une suspension contenant de l'eau ou une émulsion sous forme d'aérosol, d'aérosol électriquement chargé, de mousse, d'impression ou de peinture, ou*
- *une exposition à un milieu gazeux renfermant des vapeurs de monomère, ou*
- *l'application d'une couche de matériau polymère par le biais d'une extrusion, d'une plastification, d'une impression, d'une peinture, d'un spray ou d'une manière électrostatique en utilisant une poudre, ou*
- *la mise en contact de la surface avec une autre surface ayant été traitée en utilisant le procédé décrit ci-avant, ou avec un autre matériau solide.*
